# EUROPEAN PATENT APPLICATION

(11) **EP 3 462 109 A1**
(43) Date of publication of application: **03.04.2019**
(21) Application number: 18197371.0
(22) Date of filing: 27.09.2018
(51) Int. Cl.: F25B 27/00, H01L 51/42, H02S 10/40, H02S 30/20, H02S 40/42

(54) **ORGANIC PHOTOVOLTAIC POWERED REFRIGERATION AND FREEZER SYSTEM**

(30) Priority: 27.09.2017 GR 20170100441
(71) Applicant: Organic Electronic Technologies Private Company, 57001 Thermi Thessalonikis (GR)
(72) Inventor: LOGOTHETIDIS, Stergios, 54640 Thessaloniki (GR)
(74) Representative: Petsis, Christos

(57) **Abstract**

The present invention relates to a Refrigeration and Freezer System which is powered by a flexible lightweight solar energy system. Said system is remarkable in that it uses a flexible lightweight solar energy system based on Organic Photovoltaics. Said system is also remarkable in that it uses a lightweight solar energy system consisting of portable, folding units based on Organic Photovoltaic modules, assembled with a specially designed connector for electrical connection to a low-current operation charger for management the charging power in an accumulator.

## Description

### Field of the Invention

The present invention relates to the field of energy production of standalone portable systems. More specifically, the present invention relates to a flexible lightweight solar energy system based on Organic Photovoltaics fabricated on plastic substrates that can be easily transported and set up to generate electrical power to DC refrigeration and freezer devices in a variety of environments.

### Background of the invention

Said solar powered refrigeration and freezer system is referred to herein as a refrigeration and freezer system that runs on solar energy. Previous attempts to produce a marketable solar refrigerators and freezers have been demonstrated using solar energy systems from Silicon Photovoltaic Panels as described in patents US 4,126,014, US5,685,152, CN202333859U and US6,453,693. Actually, such solar energy systems that are easily fragile and heavy -notably c-Si panel ∼22Kg/m²- are not easily transportable and not applicable to be incorporated in complex inclined and/or curved surfaces. Additionally, these known solar energy systems are rigid and exhibit low efficient performance under high temperatures.

### Aim of the invention

In view of existing technology of the prior art in this field, a lightweight, flexible solar energy system that can operate under low light conditions and mainly under high temperatures is desirable. For such solar powered refrigeration and freezer energy systems, the implementation of high conformable energy generating products like Organic Photovoltaics -commonly designated hereafter as OPVs- that revolutionizes solar energy generation on plastic substrates and that can be also semitransparent is preferable.

OPV panel technology as such is already known in the art. However, applications that use lightweight and flexible OPV panel kit or arrays as a solar energy system to power DC refrigeration and freezer systems, have not been provided yet.

### Summary of the invention

There is proposed according to the invention a flexible lightweight solar energy system that can be adapted with simple procedures to any surface regardless of dimension and shape, combined with high aesthetic and easy maintenance for generate electrical power to DC refrigeration and freezer devices. This flexible lightweight solar energy system consists of an OPV panel or a set of OPV panels that constitute an array, assembled with a designed connector and solar charge controller.

Said flexible lightweight solar energy system of the invention is based on Organic Photovoltaics that are manufactured in vacuum, ambient or/and inert atmospheres by Roll-to-Roll (R2R) processing on low cost flexible substrates with standard coating and printing techniques like screen, inkjet, offset, gravure, flexography, slot die, spray, doctor blading, pad printing or knife over roll printing, and also by Organic Vapor Phase Deposition processes on plastic substrates under inert and high vacuum conditions.

This invention thus features the use of OPV panels as an alternative solution of using Si-based PVs in solar powered refrigerators and freezers applications. Polymer based or small molecule OPVs manufactures on plastic substrates exhibit advantageous properties over the existing Si-based PVs of the art, since they have very low weight ≤0,5 Kg/m², high conformability and stretchability for easy adaptation, offering freedom of design, coloring and aesthetic, and efficient performance under diffuse light, indoor conditions and under high temperatures.

OPVs exhibit simplicity in adaptation onto any surface without degradation and cracks. In particular, said surface can thus be either of flat or curved shape, and made of plastic, glass, textile or concrete. Additionally, OPVs exhibit simplicity in installation and maintenance, since their performance is independent by the irradiation angle, thus they do not need to adjust their tilt two times per year according to the season, as Si-based PVs do. Moreover, OPVs are userfriendly and also eco-friendly.

In this respect, thanks to the invention, the energy consumption required to manufacture an OPV panel is less than the amount of energy required for a Si-based PV panel.

Organic Photovoltaics are easily manufactured compared to Si-based PVs due to their molecular nature of the materials used. Indeed, molecules are easier to work with thin film substrates that are several times thinner than silicon results to low energy manufacturing that allows reducing the cost production significantly, which is considered a noticeable advantage according to the invention. Therefore, the energy saving is higher on OPV manufacturing compared to Si-based PVs; particularly for solar powered refrigerators/freezers could contribute to the increased use of solar power globally and make renewable energy sources more attractive to the average consumer.

Thanks to the present invention, there is thus proposed an Organic Photovoltaic Powered Refrigeration and/or Freezer System that runs on solar energy collected by Organic Photovoltaics onto plastic substrates.

In this respect, it was recognised herewith that a desirable lightweight, flexible low-cost solar energy system manufactured by flexible Organic Photovoltaics with a connector easy to use and adequate solar charge controller which is valuable for powering DC refrigeration and freezer systems in a variety of environments.

According to a more particular embodiment of the invention, the flexible, lightweight solar energy system is transportable and easily collapsible directly to the metallic surfaces of a refrigerator/freezer/fridge or to the fabric/plastic rooftop of a refrigerator cart or upon lightweight canopy constructions that prevent a refrigeration and freezer device. This invention is quite suitable for a full day of energy autonomy, notably for ice-cream and food and drinks refrigerator carts.

According to an additional aspect of the application of the invention, it is also applicable to vaccine refrigerators on aid work in Africa and India for example.

According to another aspect of the invention, it can also be used for solar refrigerators/freezers on RV, boats and boating trips, beach bars, camping trips, cabins and for other off-grid applications. Indisputably, OPV panel arrays can also be used on buildings facades and windows and on the rooftops of greenhouses for energy autonomy of any refrigeration and freezer device which is housed.

In a main embodiment of the invention, the OPV Solar Powered Refrigeration and/or Freezer System is in the form of at least one OPV panel kit or array that includes a number of individual OPV panel kits electrically connected together, in electrical communication with a solar charge controller wired with an accumulator that is connected with a DC refrigeration and/or freezer device.

The present invention also consists of a connection method that incorporates and executes it. In an additional embodiment of the invention, a connector is disclosed for coupling with the electrodes of an OPV panel that are wired out using conductive tape, to structure a completed individual portable OPV panel kit with a twin cable. The lightweight flexible OPV panel kit which is easily transportable can be in many different sizes and shapes and can unfurl and roll up easily without degradation. Additionally, the OPV panel kit is with customizable coloring on a color palette of grey, red-brown, blue and green by combining various photoactive materials and electron acceptors. In a further embodiment of the invention, a solar charge controller for OPV panel kits is disclosed. The solar charge controller comprises constant current sources since OPV panels are operating on low current-voltage characteristics. This solar charge controller can supply steady current even if there are changes in resistance from the electrical fluctuations of the OPV panels to charge efficiently an accumulator.

Further features and properties of the Organic Photovoltaic Powered Refrigeration and/or Freezer System and the connection method will emerge from the following description in detail of some embodiments of the invention, which are illustrated with the aid of the attached drawings.

### Brief description of the drawings

FIG. 1 is a diagrammatic representation showing an embodiment of an OPV Solar Powered Refrigeration or/and Freezer System 1 based on a flexible lightweight solar energy system 2 according to the invention.
FIG. 2A is a further diagrammatic representation showing an embodiment of an OPV Solar Powered Refrigeration or/and Freezer System 1, that consists of a DC refrigeration and/or freezer system device 3, an accumulator 4, and the flexible lightweight solar energy system 2 that includes at least one OPV panel 5 with a connector 6 and solar charge controller 7.
FIG. 2B is a diagrammatic representation showing an aspect of an OPV panel array 8 consisting of a plurality of OPV panels 5 with their connectors 6, which each of them wiring together in series with twin cables 9.
FIG. 2C is a further diagrammatic representation showing an embodiment of an OPV Solar Powered Refrigeration or/and Freezer System 1 based on a flexible lightweight solar energy system 2 according to the invention, that includes an OPV panel array 8 assembled with a solar charge controller 7 which is connected to an accumulator and a DC refrigeration and/or freezer system device 3.
FIG. 3 is a diagrammatic representation showing an aspect of an OPV Solar Powered Refrigeration or/and Freezer System configured for residential applications 10 according to the invention.
FIG. 4 is a realistic view showing an aspect of a full printed OPV panel 13 manufactured by R2R printing and coating processes onto plastic substrate.
FIG. 5A and 5B are schematic representations of an OPV panel kit 14 defined by a R2R Printed OPV panel 5a assembled with special connector 6a.
FIG. 6A-6C each represents schematically the connector illustrating the parts that constitute the connector 6a for a R2R full printed OPV panel.
FIG. 7 is an electrical scheme showing the solar charge controller 7 operating on a constant current source circuit 22.
FIG. 8 is further electrical scheme showing an OPV solar energy cluster 29 consisting of multiple OPV panel arrays 8 and each of them connected to a solar charge controller 7 which ends up to its electrodes to an accumulator 4.
FIG. 9A illustrates an OPV Powered Refrigeration or/and Freezer system 1 solar powered by multiple OPV panel arrays mounted on a tent 23 rooftop.
FIG. 11B is a mixed representation of an OPV Powered Refrigeration or/and Freezer system 1 solar powered by a flexible solar energy system 2 in the form of an OPV pane! kits net 24.
FIG. 11C is an illustration of an OPV Powered Refrigeration or/and Freezer system 1 solar powered by OPV panel kits 14 or arrays 8 that are adapted directly to the metallic surfaces of a DC refrigeration and/or freezer device 3.
FIG. 11D illustrates a refrigerator cart 26 with an OPV Powered Refrigeration or/and Freezer system 1.

### Description

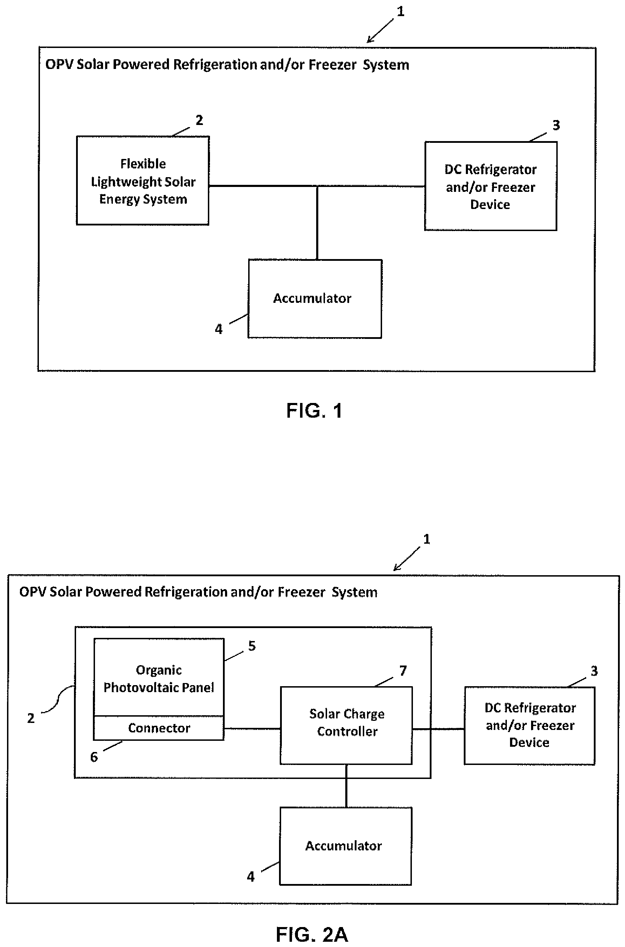

The present invention relates to an OPV Solar Powered Refrigeration and/or Freezer System, as discussed in detail below in connection with FIGS **1-9**.

FIG. **1** is diagrammatic representations showing a first embodiment of a Solar Powered Refrigeration or/and Freezer System 1 based on a flexible lightweight OPV solar energy system 2 according to the invention. OPV Solar Powered Refrigeration and/or Freezer System **1** consists of a DC refrigeration and/or freezer system device **3** which is powered by a flexible lightweight solar energy system **2** accomplished through an accumulator **4**.

Flexible lightweight solar energy system converts sunlight into DC electrical power and storage in accumulator. This electricity is controlled via a DC controller that operates on low currents which ensures that accumulator is charged properly and not damaged and that power is not lost or discharged.

OPV powered refrigerators and freezers operate on the same principle as normal compression refrigeration and freezer DC devices that run on solar energy using at least one OPV panel **5**, which produces a DC current and voltage. OPV powered refrigerators and freezers since being DC powered can be operated independently from the electric grid. This means that is not required an inverter to operate, fact that is ideally suited for off-grid locations or locations where power interruptions are common and daily occurs. OPV powered refrigerators and/or freezers incorporate low voltage of 12 or 24V DC compressors and motors compared to main voltage AC type refrigeration and freezer devices. Preferably, a DC compressor with good efficiency requires a DC type battery as an accumulator. DC Refrigeration and freezer systems can then be powered directly from the battery. Under condition without sunlight, the spare battery has enough electricity to supply refrigerator for some days. A capacity of battery to run the refrigerator for five days without sun is recommended.

Also, DC variable speed compressors are preferable for OPV powered refrigeration and/or systems since they increase system's efficiency while reducing the number of daily start/stop sequences. To increase energy efficiency, an OPV powered refrigeration and/or freezer system requires having higher levels of insulation around the storage compartments.

The design of the DC refrigeration and/or freezer device due to the thermal loss associated with openings is preferably of the chest type cabinets rather than a container with a door, as the cool and heavy air mainly remains inside the cabinet. Finally, it is required not to open the refrigerator more than strictly necessary.

FIG. **2A** is a diagrammatic representation of an OPV Solar Powered Refrigeration and/or Freezer System **1** that includes a flexible lightweight solar energy system 2, that according to a second embodiment consists of at least one OPV panel 5 with a special connector 6 which is electrically connected with a solar charge controller 7 which ensures proper accumulator charging of OPV systems. This solar set up is preferred for powering small DC refrigeration and/or freezer devices.

Nevertheless, when the power requirements of a refrigeration and/or freezer device are higher, a solar set up using an OPV panel array is recommended.

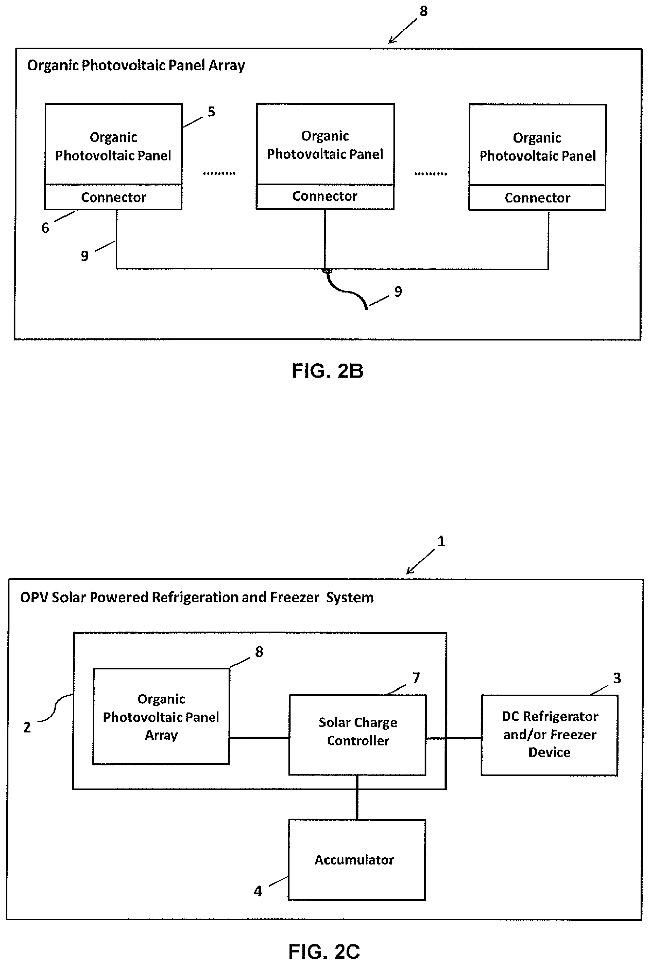

FIG. **2B** is a further diagrammatic representation of FIG.2A showing an OPV panel array **8** consists of multiple OPV panel **5** interconnected togetherin a series connection. The serial connection is chosen in order to work as a wire for transferring the current to the next panel without interfering the total circuitry, when an OPV panel stops operating. A twin cable **9** from the OPV panel array is available to connect to the solar charge controller **7**. Then accumulator 4 provides directly the stored electricity to energize a refrigeration and/or freezer device with an efficient DC compressor. In that way, a flexible lightweight solar energy system 2 based on OPV panel array is defined as shown in FIG. 2C.

The OPV panel array **8** is normally sized to ensure that enough power is supplied to the solar powered refrigeration or/and freezer systems according to the requirements of their power consumption. The power consumption varies by storage capacity and model. A typical DC low power consumption vaccine refrigerator of 49 It consumes 8,5 Wh per h and an Ultra Energy Efficient Solar (battery) Powered Fridge/Freezer of 433 it consumes 75 Wh per h. Additionally, parameters for selecting the appropriate size of the OPV panel array depend on accumulator efficiency (Wh), cable losses, solar controller efficiency, manufacturing tolerance of OPV panels, dirt, weather conditions and solar radiation levels at different periods of the year, depending on where they are located globally. The available energy of OPV panel array in order to power low pressure DC compressor refrigeration and/or freezer device is required to range between 100-200 Wh. To achieve a high-wattage requirement, a number of OPV panel arrays are electrically connected together in series, parallel, or a combination of the two in order to structure an OPV solar energy cluster **29** which is efficient to support the operation of an OPV powered refrigeration and/or freezer system.

The OPV powered refrigeration and/or freezer system is purpose-designed to match the power consumption of the connected refrigeration equipment as well as the site-specific climate conditions, taking into consideration ambient temperatures, available solar radiation at the site of installation and autonomy requirements.

The choice of the site/position/orientation/ tilt of OPV panel array roof mounting on a solar powered refrigeration and freezer system is not crucial for its performance and efficiency, since it can operate efficiently in different inclinations and it is effective in bright and low light. The most frequent maintenance need of OPV panels is the cleaning of the panel surface. Dirt or other debris on the OPV panel surface should be removed since they block sunlight and reduce the energy output of the system.

Finally, the recommended size of the storage battery for the OPV powered refrigeration and/or freezer system 1 is depending on the need for continuous operation. A risk could appear only if OPV panel array mismatch with the battery, which may result in the battery te running full on sunny days. Lead acid batteries are very heavy and toxic. Unlike this, power packs for battery powered OPV refrigeration and/or freezer systems are recommended which are equipped either with dry charged or Sealed Gel batteries with proof of conformity to IEC 61427/IEC 60 896-21, 22. Strictly specification for both types of batteries is their capability of withstanding a minimum of 1000 cycles to 50% Depth of Discharge (DOD); otherwise to permit a minimum of 5 days of continuous operation when the photovoltaic array is exposed to limited irradiance, cloudy or rainy days and cannot power the battery. Preferably, it needs for long life use to include the Lithium ion and Nickel Metal Hydride types. Batteries need often maintenance every three years.

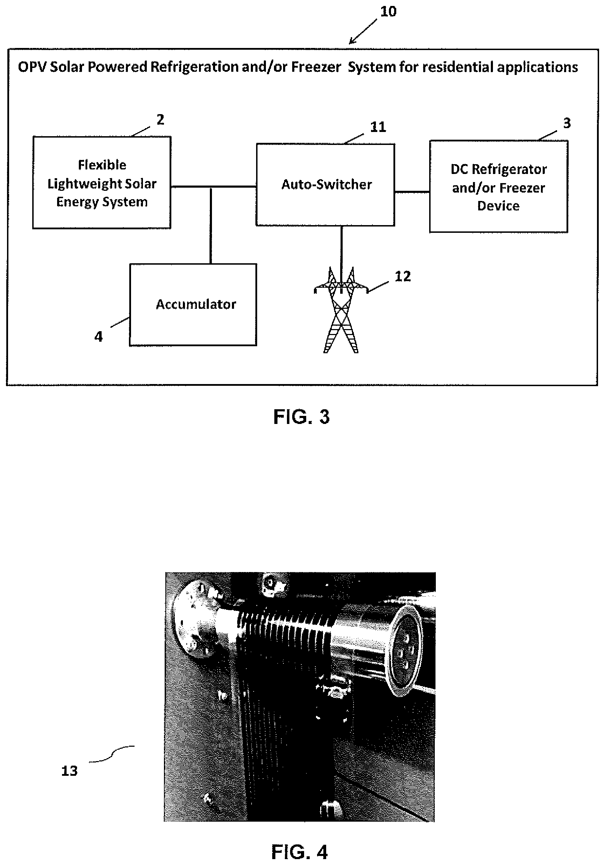

FIG. **3** is a diagram showing the OPV Solar Powered Refrigeration or/and Freezer System configured for residential applications **10**. The OPV solar powered refrigeration and freezer system is based on a first embodiment assembled additionally with an automatic switcher **11** that can changeover to grid **12**, AC electricity 110V/220V; and when the OPV panels array can provide electricity to charge the battery, it will go back to DC solar power 12V/24V.

The present invention is further described in detail below, by way of non-limiting example and with reference to the accompanying drawings 4-6, which show an embodiment using R2R printed OPV panels **13**. FIG. **4** is a realistic view showing an OPV panel **13** manufactured by R2R printing and coating processes onto plastic substrates like Polyethylene Terephthalate (PET).

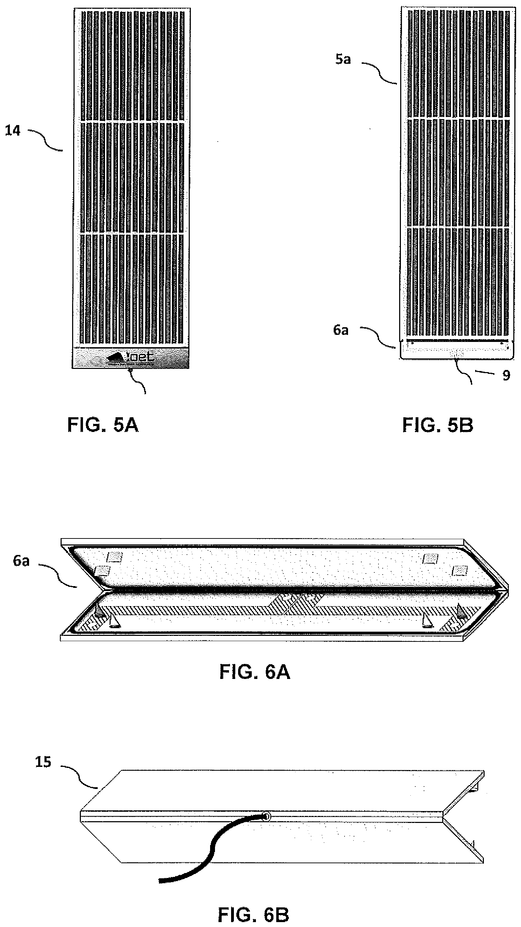

FIG. **5A-5B** is a schematic representation of an OPV panel kit **14**. The OPV panel kit is a portable flexible lightweight energy harvest device, that consists of a R2R fully printed OPV panel **18** assembled with a special connector **6a** that enables the kit 14 to connect quickly and easily in different DC powered applications.

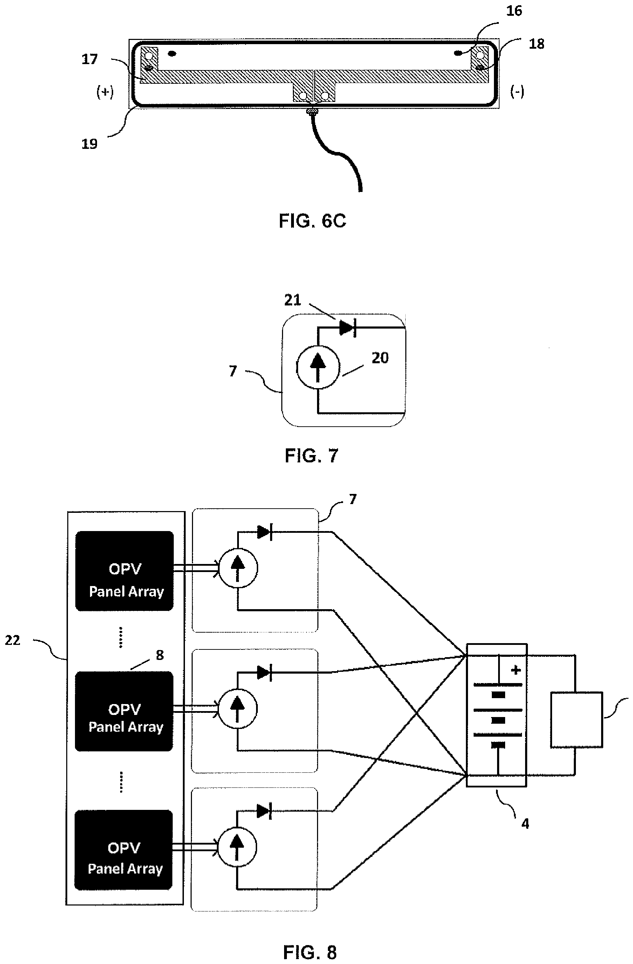

FIG. **6A-6C** represents schematically the parts that constitute the connector **6a** designed for a R2R fully printed OPV panel 13. The connector **6a** shown in FIG.6A, consists of a plastic casket **15** with case plastic pins **16** that includes two conductive plates **17**, metallic pins **18**, and an O-ring **19**. By closing the connector, the metallic pins pierce through the conductive tape of the OPV panel providing mechanical stability and electrical conductivity. The O-ring is inserted to prevent the connector from moisture and water penetration.

FIG. **7** is an electrical scheme showing the solar charge controller **7**, which is based on a constant current source circuit **20**. OPVs since they are produce low current values, a constant current source circuit is preferable. A constant current source is a power generator whose internal resistance is very high compared with the resistance of the refrigeration/freezer system it is giving power to. The solar charge controller includes also a diode **21** to prevent the current to reverse. The voltage input of the solar charge controller range from 10 V to 40 V and the current Isc 0,2-1,5 A. The voltage output can be 12 V/24 V.

FIG. **8** demonstrates an electrical scheme of an OPV solar energy cluster **22** consisting of multiple OPV panel arrays **8** and each of them is connected to a solar charge controller **7** which ends up to its electrodes to an accumulator **4** that is connected with the DC refrigeration and/or freezer device **3**.

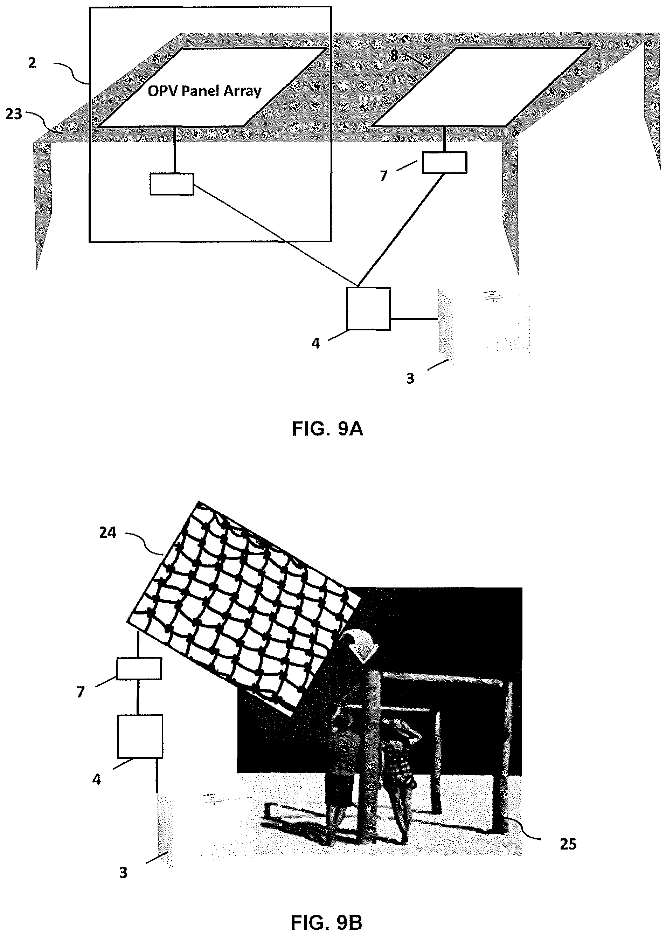

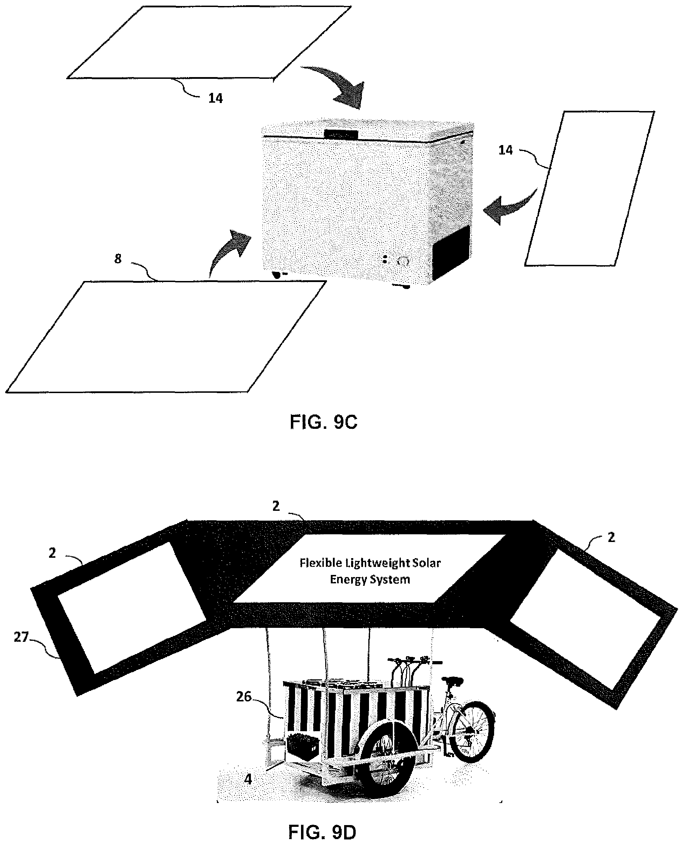

FIG. **9A-9D** show a variety of applications of OPV solar powered refrigeration and freezer systems. OPV solar powered refrigerators comply with EU and UK legislations that cover temperature control requirements during the storage and transport of perishable foods according to regulation EC No 852/2004 on the Hygiene of Foodstuffs. These requirements apply for certain categories of food which is likely to support the growth of pathogenic micro-organisms or the formation of toxins and must be kept below 8°C. FIG. **9A** shows an OPV powered refrigeration and freezer system solar powered by multiple OPV panel arrays attached on a tent **23** by applying double-sided adhesive tape or Velcro mounted. FIG. **9B** is a mixed representation of an OPV Powered Refrigeration or/and Freezer system **1** solar powered by a flexible solar energy system **2** in the form of an OPV panel kits net **24**. This OPVs panel kits net **24** is ready to hang with mechanical spacers on the four corners of standings. According to aspect **24**, the OPV solar energy system except from harvesting plays the shade role for the refrigerator/freezer system. FIG. **9C** presents an OPV Powered Refrigeration or/and Freezer system 1 solar powered by OPV panel kits **14** or arrays **8** that can unfurl and rolls up on the rooftop refrigerator lid and its sides when the climate conditions required. OPV panel kits or arrays can be attached by Velcro mounted to all metallic surfaces of the refrigerator to collect the sun from all directions. Also the attached flexible lightweight solar energy systems can shade by that way the whole cabinet of the refrigerator/freezer device.

FIG. **9D** illustrates a refrigerator cart **26** with an OPV Powered Refrigeration or/and Freezer system **1**. Flexible lightweight solar energy systems **2** attached on the tent and to its folding draperies **27**. This extension with the folding draperies can lead to higher harvesting and thus higher wattage DC power collection.

While we have shown and described the embodiments in accordance with the present invention, it should be clear to those skilled in the art that further embodiments may be made without departing from the scope of the present invention.

## Claims

1. Organic Photovoltaic Powered Refrigeration and/or Freezer System (1), **characterized in that** it consists of a DC refrigeration and/or freezer device (3) which is solar powered by a flexible lightweight solar energy system (2).

2. Organic Photovoltaic Powered Refrigeration and/or Freezer System (1) according to claim 1, **characterized in that** said flexible lightweight solar energy system (2) is based on at least one Organic Photovoltaic panel (5).

3. Organic Photovoltaic Powered Refrigeration and/or Freezer System (1) according to claim 1 or 2, **characterized in that** said flexible lightweight solar energy system (2) is based on an Organic Photovoltaic panel array (8) of Organic Photovoltaic panels (5).

4. Organic Photovoltaic Powered Refrigeration and/or Freezer System (1) according to one of the preceding claims, **characterized in that** said flexible lightweight solar energy system (2) includes at least one Organic Photovoltaic panel (5) with a connector (6), which is connected thereto and to a solar charge controller (7) that operates on low currents.

5. Organic Photovoltaic Powered Refrigeration and/or Freezer System according to one of the preceding claims 4, **characterized in that** said solar energy system includes at least one Organic Photovoltaic panel that is a portable kit (20).

6. Organic Photovoltaic Powered Refrigeration and/or Freezer System according to claim 5, **characterized in that** it is solar powered by said portable Organic Photovoltaic panel kits (20) that are mounted as a collapsible unit directly to metallic surfaces of said DC refrigerator and/or freezer device (3).

7. Organic Photovoltaic Powered Refrigeration and/or Freezer System according to one of the preceding claims, **characterized in that** the Organic Photovoltaic Solar Powered Refrigeration and/or Freezer System is in the form of at least one Organic Photovoltaic panel kit or array that includes a number of individual Organic Photovoltaic panel kits electrically connected together, in electrical communication with a solar charge controller wired with an accumulator that is connected with a DC refrigeration and/or freezer device.

8. Organic Photovoltaic Powered Refrigeration and/or Freezer System according to claim 5, **characterized in that** it is solar powered by portable Organic Photovoltaic panel kits (20) in the form of a net (31).

9. Organic Photovoltaic Powered Refrigeration and/or Freezer System according to one of the preceding claims, **characterized in that** it is integrated to a refrigerator cart (33).

10. A connector arranged for a Roll-to-Roll full printed Organic Photovoltaic panel (21) to be incorporated in said flexible lightweight solar energy system of said Organic Photovoltaic Powered Refrigeration and/or Freezer System (1) as defined in any one of the preceding claims.

11. A solar charge controller (7) based on a constant current circuit (27) for managing the power of an Organic Photovoltaic panel kit (20) or/and array (8) to an accumulator (4) to be arranged in said Flexible lightweight solar energy system (2) of said Organic Photovoltaic Powered Refrigeration and/or Freezer System (1) as defined in any one of claims1 to 9.
